# EUROPEAN PATENT SPECIFICATION

(11) **EP 0 585 137 B1**
(45) Date of publication and mention of the grant of the patent: **06.05.1998**
(21) Application number: 93306827.2
(22) Date of filing: 27.08.1993
(51) Int. Cl.: B24C 9/00, B24C 3/08, B24C 3/12, B24C 7/00

(54) **Abrasive blasting apparatus and fin removing apparatus incorporating the same**
Schleuderstrahlvorrichtung und Vorrichtung zum Entfernen von Graten mit dieser Vorrichtung
Dispositif de traitement au jet abrasif et dispositif pour enlever les bavures muni d'un tel dispositif

(30) Priority: 27.08.1992 JP 228818/92; 02.10.1992 JP 265045/92
(43) Date of publication of application: 02.03.1994
(73) Proprietor: Choi, Young Kil, Hirakata-shi, Osaka (JP)
(72) Inventor: Choi, Young Kil, Hirakata-shi, Osaka (JP)
(74) Representative: Cross, Rupert Edward Blount

(56) References cited:
- GB-A- 907 937
- GB-A- 2 232 103
- US-A- 1 578 862
- US-A- 2 261 565
- US-A- 3 385 006
- US-A- 4 561 219
- US-A- 4 674 238
- US-A- 4 760 673

## Description

### BACKGROUND OF THE INVENTION

### 1. Field of the Invention:

This invention relates to an abrasive blasting apparatus which is designed to blast abrasive particles together with high speed air for performing abrasive treatment of a workpiece. The present invention also relates to an apparatus which incorporates such an abrasive blasting apparatus for removing resin fins from a molded leadframe in the making of electronic devices.

### 2. Description of the Prior Art:

US-A-3 385 006 discloses an apparatus according to the preambles of claims 1 and 4, respectively.

In general, an abrasive blasting apparatus comprises at least one blasting nozzle arranged in a blasting chamber. The blasting nozzle is connected to an air distributing pipe and an abrasive supply hose, so that the abrasive supplied through the abrasive supply hose is entrained in the high speed air supplied through the air distributing pipe for discharging from the blasting nozzle. The abrasive thus discharged impinges on a workpiece for blasting abrasive treatment, after which the abrasive falls to a bottom portion of the blasting chamber together with the dust (e.g. resin fin dust) which results from the blasting abrasive treatment.

For circulating the thus falling abrasive to the blasting nozzle, a separator connected to a negative pressure source may be mounted above the blasting chamber, as disclosed for example in Japanese Patent Application Laid-open No. 4-63680 (Laid-open: February 28, 1992) of the same applicant. The negative pressure source may be suitably a dust catcher which incorporates a suction blower.

The separator sucks up the abrasive from the bottom portion of the blasting chamber through a recovery tube. Within the separator, the abrasive is separated from the dust and collected at a bottom portion of the separator. The collected abrasive is returned to the blasting nozzle through the abrasive supply hose.

According to the prior art arrangement described above, the separator is mounted above the blasting chamber. Though the blasting nozzle itself has an ability of generating a negative pressure for drawing in the abrasive, such a negative pressure alone is insufficient for lifting the abrasive to the level of the blasting nozzle from the bottom portion of the blasting chamber while also causing the blasting nozzle to draw in the thus lifted abrasive for discharging with the high speed air. Thus, the separator is conventionally mounted above the blasting chamber for utilizing the gravity to bring the abrasive to the blasting nozzle, thereby enabling the negative pressure of the blasting nozzle solely to draw in the abrasive in a sufficient amount.

The prior art arrangement is evidently disadvantageous in that the separator inevitably increases the overall height of the blasting apparatus. Thus, if the space is limited, it may be impossible to install the blasting apparatus. In particular, the production line for making resin-package type electronic components is generally known to require small height equipments, so that a blasting apparatus is also required to be low.

It is therefore an object of the present invention to provide an abrasive blasting apparatus which can be greatly reduced in size, particularly height, without reducing the capacity of a blasting chamber.

Another object of the present invention is to provide a fin removing apparatus which incorporates such an abrasive blasting apparatus for efficiently and effectively removing resin fins from a moulded leadframe.

According to one aspect of the present invention, there is provided an abrasive blasting apparatus comprising a blasting chamber; at least one blasting nozzle disposed in the blasting chamber; air supplying means for supplying air to the blasting nozzle; abrasive supplying means for supplying an abrasive to the blasting nozzle for discharging with the air; and abrasive recovering means connected to the abrasive supplying means for collecting the discharged abrasive and for circulating the collected abrasive to the abrasive supplying means; the abrasive recovering means comprising at least one abrasive suction inlet arranged at a lower portion of the blasting chamber and connected to the abrasive supplying means; characterised in that the abrasive recovering means further comprises at least one air discharge pipe having a discharge end in facing relation to the abrasive suction inlet with a clearance, the air discharge pipe having a non-constricted air passage and being connected to a blower which is separate from the air supplying means for the blasting nozzle.

According to the arrangement described above, the air discharged from the air discharge pipe into the abrasive suction inlet imparts a dynamic pressure to the abrasive drawn in the abrasive suction inlet, thereby pumping the abrasive back to the blasting nozzle. In addition, the blasting nozzle itself inherently generates a negative pressure for drawing in the abrasive. Thus, the pumping function provided by the abrasive recovery means is skilfully combined with the inherent sucking function of the blasting nozzle for lifting the abrasive from the bottom portion of the blasting chamber to the blasting nozzle and for discharging the abrasive.

In this way, no separator need be arranged above the blasting chamber. As a result, it is possible to reduce the overall height of the blasting apparatus without reducing the capacity of the blasting chamber.

Preferably, at least one of the abrasive suction inlet and the air discharge pipe is positionally displaceable to adjust the clearance. Further, it is also preferable that the air discharge pipe is coaxial with the abrasive suction inlet, and that the discharge pipe has an outer diameter smaller than an inner diameter of the abrasive suction inlet.

According to another aspect of the present invention there is provided an apparatus for removing resin fins from a moulded leadframe, the apparatus comprising a blasting chamber; a transfer assembly for transferring the leadframe in the blasting chamber substantially horizontally; at least one blasting nozzle disposed in the blasting chamber and directed toward the leadframe transferred by the transfer means; air supplying means for supplying air to the blasting nozzle; abrasive supplying means for supplying an abrasive to the blasting nozzle for discharging with the air toward the leadframe; and abrasive recovering means connected to the abrasive supplying means for collecting the discharged abrasive and for circulating the collected abrasive to the abrasive supply means; the abrasive recovering means comprising at least one abrasive suction inlet arranged at a lower portion of the blasting chamber and connected to the abrasive supplying means; characterised in that the abrasive recovering means further comprises at least one air discharge pipe having a discharge end in facing relation to the abrasive suction inlet with a clearance, the air discharge pipe having a non-constricted air passage and being connected to a blower which is separate from the air supplying means for the blasting nozzle.

According to an embodiment of the present invention, the transfer assembly comprises a parallel pair of rail members arranged substantially horizontally in the blasting chamber and spaced transversely of a leadframe transfer path for slidably supporting longitudinal edges of the leadframe, each of the rail members having a V-shaped guide groove, the transfer assembly further comprising a moving mechanism for moving the leadframe along the pair of rail members.

According to another embodiment of the present invention the transfer assembly comprises a pair of endless moving members arranged substantially horizontally in the blasting chamber and spaced transversely of a leadframe transfer path for supporting longitudinal edges of the leadframe while also moving the leadframe. The pair of endless moving members may comprise a pair of endless transfer chains. Alternatively, the pair of endless moving members may comprise a pair of endless transfer belts having at least one opposite pair of V-shaped grooves for engagement with the longitudinal edges of the leadframe.

Preferably the spacing between the pair of endless moving members is adjustable by an adjusting mechanism, so that the transfer assembly may be adapted to a particular size of the leadframe. Preferably, the adjusting mechanism comprises at least one pair of movable members supporting the pair of endless moving members, the movable members being spaced transversely of the leadframe transfer path, the adjusting mechanism further comprising screw means for moving the movable members forward and away from each other.

Preferably, the moving mechanism of the transfer assembly comprises a plurality of engaging pawls spaced along the leadframe transfer path, each of the engaging pawls coming into pushing engagement with the leadframe.

Other objects and advantages of the present invention will become apparent from the following detailed description of the preferred embodiments given with reference to the accompanying drawings.

In the accompanying drawings:
Figure 1 is a schematic front view, in vertical section showing a fin removing apparatus embodying the present invention,
Figure 2 is a schematic sectional view taken along lines II-II in Figure 1;
Figure 3 is a sectional view taken along lines III-III in Figure 2;
Figure 4 is a sectional view taken along lines IV-IV in Figure 3;
Figure 5 is a fragmentary front view showing a feeding assembly incorporated in the fin removing apparatus;
Figure 6 is a sectional view taken along lines VI-VI in Figure 5;
Fig. 7 is a sectional view taken along lines VII-VII in Fig. 1;
Fig. 8 is a schematic front view, in vertical section, showing another fin removing apparatus embodying the present invention;
Fig. 9 is a schematic sectional view taken along lines IX-IX in Fig. 8;
Fig. 10 is a plan view showing an entry portion of a transfer assembly incorporated in the fin removing apparatus of Fig. 8;
Fig. 11 is a sectional view taken along lines XI-XI in Fig. 10;
Fig. 12 is a sectional view taken along lines XII-XII in Fig. 11;
Fig. 13 is a plan view showing an exit portion of the transfer assembly;
Fig. 14 is a sectional view taken along lines XIV-XIV in Fig. 13;
Fig. 15 is a sectional view taken along lines XV-XV in Fig. 14;
Fig. 16 is a sectional view taken along lines XVI-XVI in Fig. 14;
Fig. 17 is a sectional view taken along lines XVII-XVII in Fig. 8;
Fig. 18 is a plan view similar to Fig. 13 but showing an exit portion of a modified transfer assembly;
Fig. 19 is a sectional view taken along lines XIX-XIX in Fig. 18; and
Fig. 20 is a plan view showing a molded leadframe to be treated for fin removal.

### DETAILED DESCRIPTION OF THE PREFERRED EMBODIMENTS

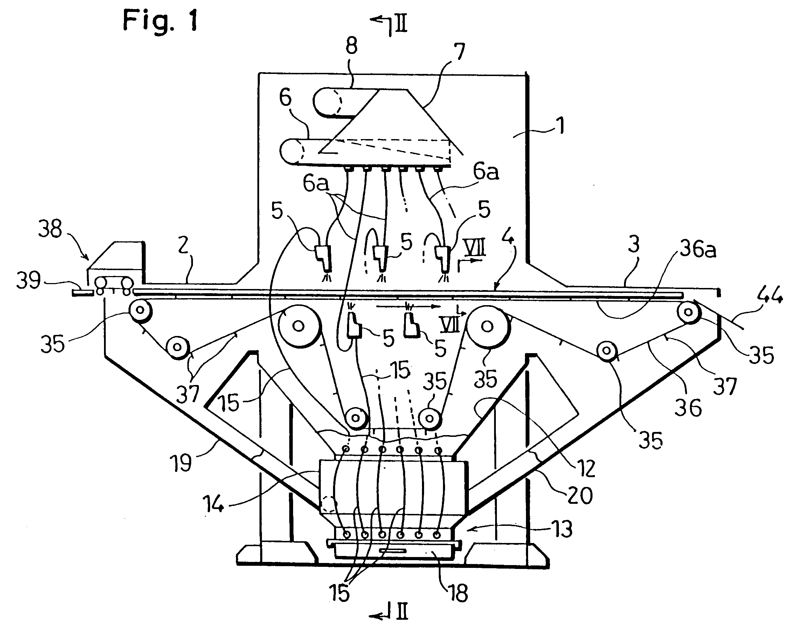

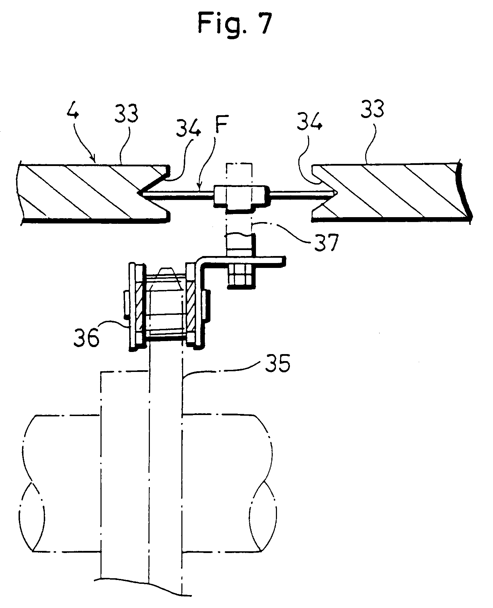

Reference is first made to Figs. 1 through 7 which shows a fin removing apparatus according to a first embodiment of the present invention. The fin removing apparatus is used for removing resin fins from a molded leadframe F (see Fig. 7).

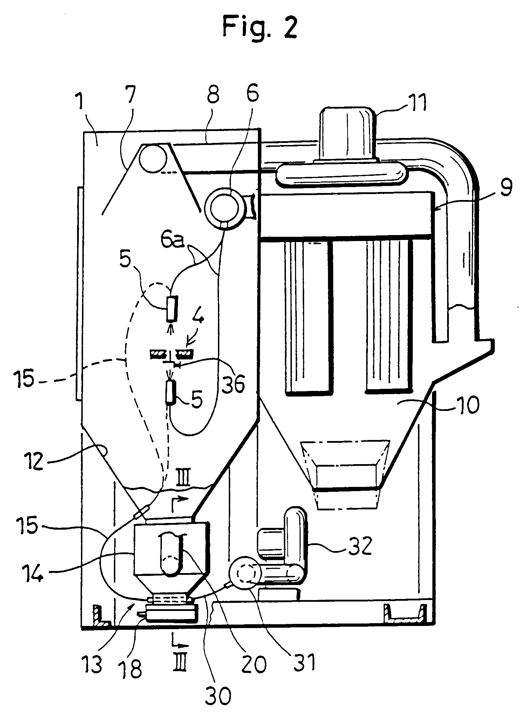

As shown in Figs. 1 and 2, the fin removing apparatus of the first embodiment includes a blasting chamber 1 flanked by an entry container 2 and an exit container 3. These containers are held in communication with the blasting chamber 1. A transfer assembly 4 extends substantially horizontally through the blasting chamber 1 and the containers 2, 3 for transferring the leadframe F, as described more in detail hereinafter.

A plurality of blasting nozzles 5 are arranged above and below the leadframe F transferred by the transfer assembly 4 with their respective nozzle openings directed toward the leadframe F. The blasting nozzles 5 are connected to an air distributing pipe 6 through respective air supply hoses 6a. The air distributing pipe 6 is arranged in the blasting chamber 1 at an upper portion thereof and connected to a low-pressure air generating source (not shown) such as a Root's blower.

As shown in Fig. 2, an umbrella-like dust collecting hood 7 is also disposed at an upper portion of the blasting chamber 1 slightly behind the air distributing pipe 6. The hood 7 has a top portion connected through a dust pipe 8 to a dust catcher 9 arranged outside and behind the blasting chamber 1. The dust catcher 9, which may be a conventional one, comprises a dust collecting chamber 10, and a suction blower 11 arranged above the chamber 10 for sucking in dust-laden air through the dust pipe 8 into the dust collecting chamber 10. The dust is removed within the dust collecting chamber 10 by filtration.

The blasting chamber 1 has a bottom hopper portion 12 which diametrically reduces downward. The hopper portion 12 is connected to an abrasive recovery assembly 13 arranged under the hopper portion 12.

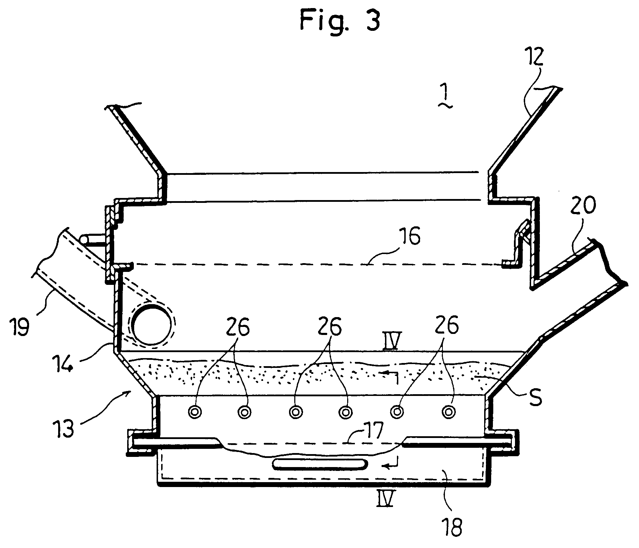

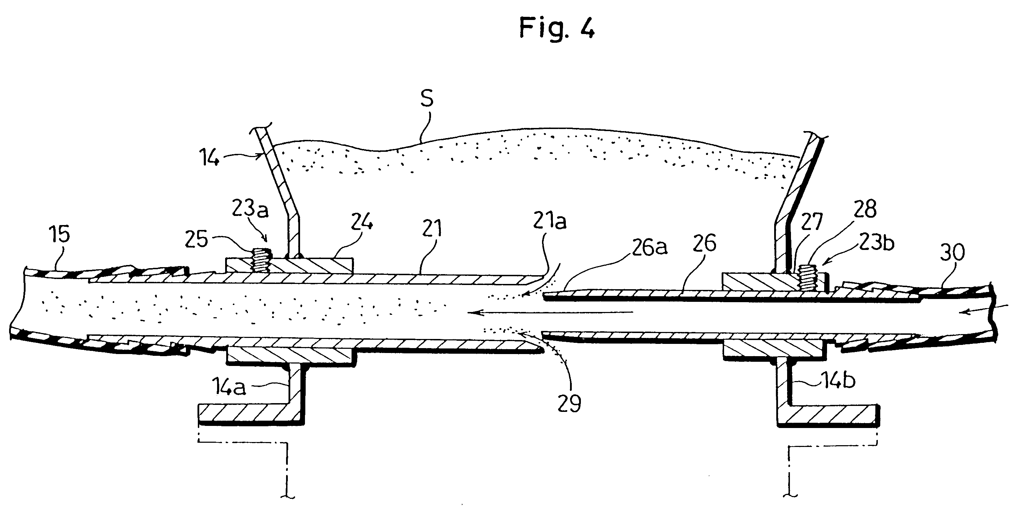

As more specifically illustrated in Figs. 3 and 4, the abrasive recovery assembly 13 includes a collector container 14 connected to the lower end of the hopper portion 12 for receiving the abrasive S falling from the hopper portion 12. The collector container 14 is provided, at an upper portion thereof, with a drawer-type screen 16 for removing coarser fin dust while allowing passage of finer fin dust and the abrasive S. The collector container 14 is also provided, at a lower portion thereof, with a drawer 18 which includes a screen 17 having a mesh size smaller than the particle size of the abrasive S. Thus, the lower screen 17 prevents passage of the abrasive S while admitting finer fin dust into the drawer 18 for removal.

Further, the collector container 14 is connected to the entry and exit containers 2, 3 through respective ducts 19, 20 (see Figs. 1 and 3). Thus, portions of the abrasive S falling into the entry and exit containers 2, 3 are guided into the collector container 14.

The abrasive recovery assembly 13 further includes a plurality of abrasive suction pipes 21 each having a suction inlet 21a, and a corresponding number of air discharge pipes 26 (see Fig. 3) each having a discharge end 26a in axial alignment with the suction inlet 21a of a corresponding abrasive suction pipe 21 with an annular clearance 29 (see Fig. 4) formed therebetween. When air is discharged from the discharge pipes 26 respectively into the abrasive suction pipes 21, the abrasive S is drawn into the suction pipes 21 and carried by the air.

The abrasive suction pipes 21 are connected to the respective blasting nozzles 5 through respective abrasive supply hoses 15, as shown in Figs. 1, 2 and 4. Similarly, the air discharge pipes 26 are connected through respective air supply hoses 30 to a common surge tank 31 which is in turn connected to a blower 32, as shown in Fig. 2.

As shown in Fig. 4, each of the abrasive suction pipes 21 is mounted substantially horizontally to a wall portion 14a of the collector container 14 by means of a first adjusting mechanism 23a. The first adjusting mechanism 23a comprises a mounting sleeve 24 penetrating through and fixed to the wall portion 14a for slidably receiving the suction pipe 21, and a set screw 25 radially extending through the sleeve 24 into engagement with the suction pipe 21. Thus, the suction pipe 21 is horizontally (axially) adjustable in position by loosening and tightening the set screw 25.

Similarly, each of the air discharge pipes 26 is mounted substantially horizontally to another wall portion 14b of the collector container 14 by means of a second adjusting mechanism 23b. The second adjusting mechanism 23b comprises a mounting sleeve 27 penetrating through and fixed to the wall portion 14b for slidably receiving the discharge pipe 26, and a set screw 28 radially extending through the sleeve 27 into engagement with the discharge pipe 26. Thus, the discharge pipe 26 is horizontally (axially) adjustable in position by loosening and tightening the set screw 28.

As clearly appreciated from Fig. 4, the outer diameter of each air discharge pipe 26 is rendered smaller than the inner diameter of each abrasive suction pipe 21. Further, the suction inlet 21a of the suction pipe 21 internally flares toward the discharge pipe 26, whereas the discharge end 26a of the discharge pipe 26 externally tapers toward the suction pipe 21. The annular clearance 29 between the suction inlet 21a and the discharge end 26a is adjustable in size (including both radial and axial dimensions) by positionally adjusting one or both of the suction and discharge pipes 21, 26.

In operation, a suction force is applied to the dust collecting hood 7 under the action of the dust catcher 9 (the suction blower 11). Further, the unillustrated blower is actuated to supply air to the respective blasting nozzles 5 through the air distributing pipe 6 and the air supply hoses 6a, whereas the other blower 32 is actuated to supply air to the respective air discharge pipes 26 through the surge tank 31 and the air supply hoses 30. During the blasting operation, the abrasive S in a given amount is circulated for repeated blasting operation. Suitable examples of abrasive S includes particles of a resin such as polyvinyl resin or particles obtained by crushing walnut (chestnut) or apricot shells.

The abrasive is blasted by high speed air from the respective blasting nozzles 5 for removal of resin fins from the leadframe F (see Fig. 7). The abrasive thus blasted in the blasting chamber 1 falls gravitationally into the collector container 14 (Fig. 4). Upon entry into the collector container 14, coarser fin dust contained in the abrasive is separated by the upper screen 16 for removal.

A portion of finer fin dust, which is relatively small in specific weight, is fluidized by the air within the blasting chamber and carried to the dust collecting hood 7 for removal by the dust catcher 9 (Fig. 2). On the other hand, a portion of finer fin dust, which is relatively large in specific weight, moves downward with the blasted abrasive but is separated therefrom by selectively passing through the lower screen 17, as previously described.

At the abrasive recovery assembly 13, air flowing at high speed through each air discharge pipe 26 is supplied into the corresponding abrasive suction pipe 21 to pump the abrasive S into the suction pipe 21 through the annular clearance 29. Further, a negative pressure is generated at each blasting nozzle 5 (Fig. 1) by the high speed air flow supplied through the corresponding air supply hose 6a, thereby blasting the abrasive toward the leadframe F. In this way, the pumping force (or dynamic pressure) generated at the suction pipe 21 is combined with the negative pressure generated at the blasting nozzle 5 for effectively transferring the abrasive to a relatively high level of the blasting nozzle 5. Thus, it is unnecessary to provide an additional separator above the blasting chamber 1.

In addition, the size of the annular clearance 29 is adjustable by horizontally (namely, axially) displacing one or both of the abrasive suction pipe 21 and the air discharge pipe 26. Thus, it is possible to adjust the amount of the abrasive blasted from each blasting nozzle 5 per unit time depending on the kind, particle size, and etc. of the abrasive.

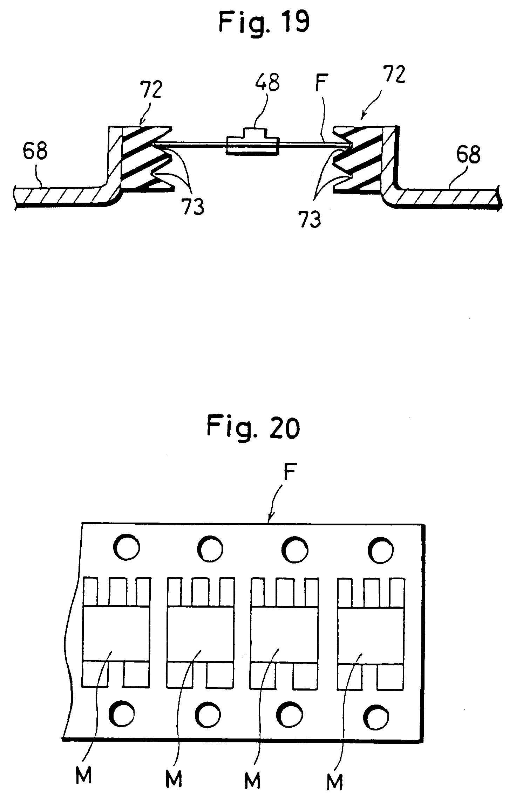

As shown in Fig. 20, the leadframe F which is treated by the illustrated fin removing apparatus is a strip formed by punching a thin metal sheet. The leadframe F is used for manufacturing semiconductor devices which are enclosed respectively in molded resin packages M arranged in an array at constant spacing. The illustrated fin removing apparatus is designed to conveniently remove, by abrasive blasting, the fins which are inevitably formed at the time of molding the resin packages M while the leadframe F is transferred horizontally. The transfer of the leadframe F is performed by the transfer assembly 4, as previously described.

As shown in Fig. 7, the transfer assembly 4 comprises a pair of transversely spaced rail members 33 extending substantially horizontally from the entry container 2 to the exit container 3 through the blasting chamber 1. The pair of rail members 33 is provided with an opposed pair of V-shaped guide grooves 34, and the spacing between the guide grooves 34 at their respective bottoms is made to correspond generally to the width of the leadframe F. Thus, the opposite longitudinal edges of the leadframe F are slidably caught in the respective guide grooves 34 while the leadframe F moves along and between the rail members 33.

As shown in Figs. 1, 5 and 7, an endless transfer chain 36 is guided by a train of sprockets 35 under the pair of rail members 33. At least one of the sprockets 35 is a drive sprocket which is connected to an unillustrated motor for moving the chain 36.

The transfer chain 36 has a horizontal transfer path portion 36a (see Fig. 1) extending immediately under and along the pair of rail members 33. The chain 36 carries a plurality of engaging pawls 37 at constant interval for pushing engagement with the leadframe F along the horizontal transfer path portion 36a (see Fig. 7).

According to the above-described arrangement of the transfer assembly 4, the leadframe F is transferred with its longitudinal edges slidably caught in the guide grooves 34 of the respective rail members 33 which are spaced transversely of the leadframe transfer path. Thus, the leadframe F can be held mostly exposed upward and downward, thereby enabling the blasting nozzles 5 to conveniently remove the resin fins which are inevitably formed at the time of molding the resin packages M.

Preferably, the rail members 33 are advantageously made of a electrically conductive metal for allowing escape of the electrostatic charge which might be generated by the abrasive blasting operation. As a result, the fin dust once abraded away from the leadframe F is prevented from being re-attached to the leadframe due to the static electricity.

At the entry end of the horizontal transfer path portion 36a of the chain 36, there is provided a feeding assembly 38 for introducing the leadframe F onto the pair of rail members 33 in synchronism with the movement of the transfer chain 36. It should be appreciated that, in actual operation, a plurality of such leadframes are successively fed onto the rail members 33.

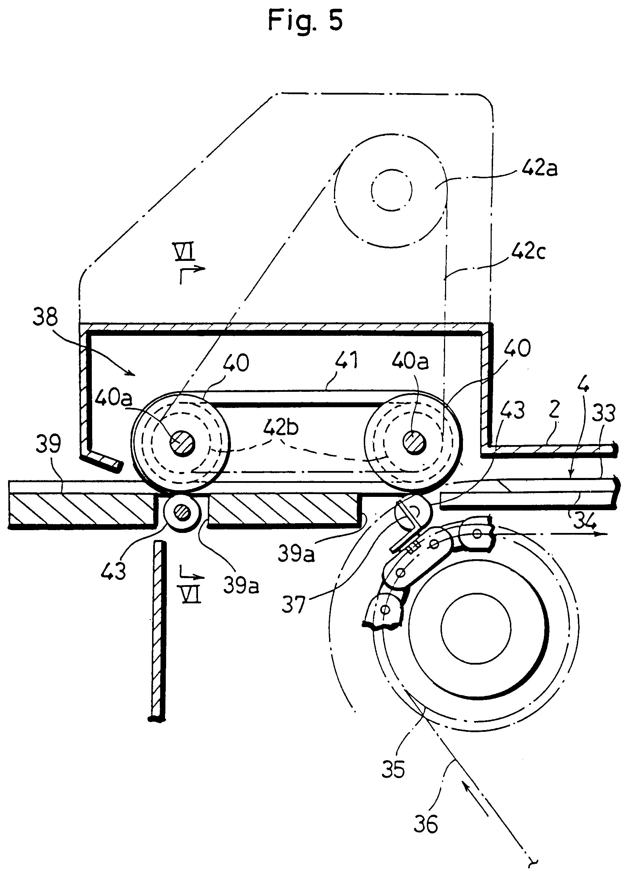

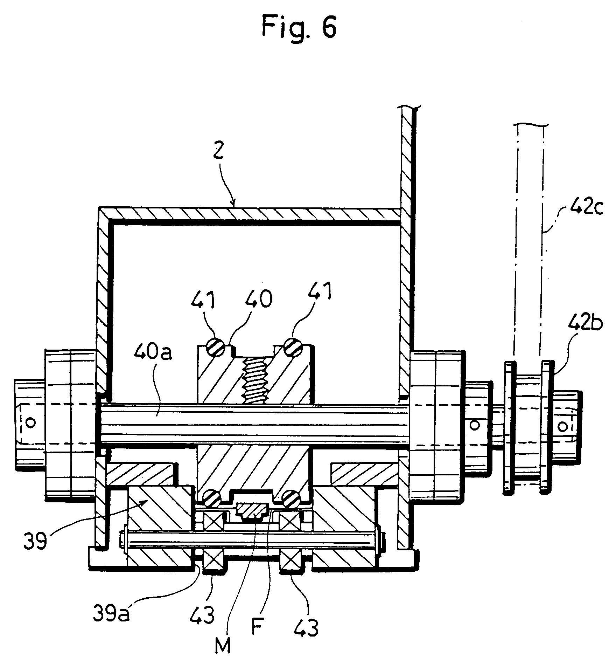

As shown in Figs. 5 and 6, the feeding assembly 38 includes a feed guide 39 having a pair of cutouts 39a which are spaced from each other in the transfer direction of the leadframe F. The feed guide 39 extends substantially horizontally and is arranged substantially at the same level as the pair of rail members 33.

The feeding assembly 38 also includes a pair of feed pulleys 40 which are supported on respective rotary shafts 40a and spaced from each other in the transfer direction of the leadframe F in corresponding relation to the cutouts 39a of the feed guide 39. The respective feed pulleys 40 are connected to each other by a pair of rubber feed belts 41. A pair of backup rollers 43 are rotatably arranged in each cutout 39a of the feed guide 39 in contact with the respective feed belts 41.

The feeding assembly 38 further includes a drive pulley 42a connected to an unillustrated motor. The drive pulley 42a is also connected through a transmission belt 42c to driven pulleys 42b which are supported on the respective rotary shafts 40a of the feed pulleys 40.

Once the leading edge of the leadframe F is inserted between the feed guide 39 and the entry side feed pulley 40 either manually or by an automatic aligning device, the feed belts 41 engage the leadframe F on both sides of the array of resin packages M (see Fig. 6) for feeding the leadframe F in synchronism with the movement of the transfer chain 36. After reaching the pair of rail members 33, the trailing edge of the leadframe F is caught by a relevant one of the engaging pawls 37 for movement along the rail members 33, as described before.

At the exit end of the transfer assembly 4, a chute 44 is provided for bringing the treated leadframe F into a collecting box (not shown) or to a next process station (not shown) which may be a cutting unit for separating the packaged semiconductor devices from the leadframe F.

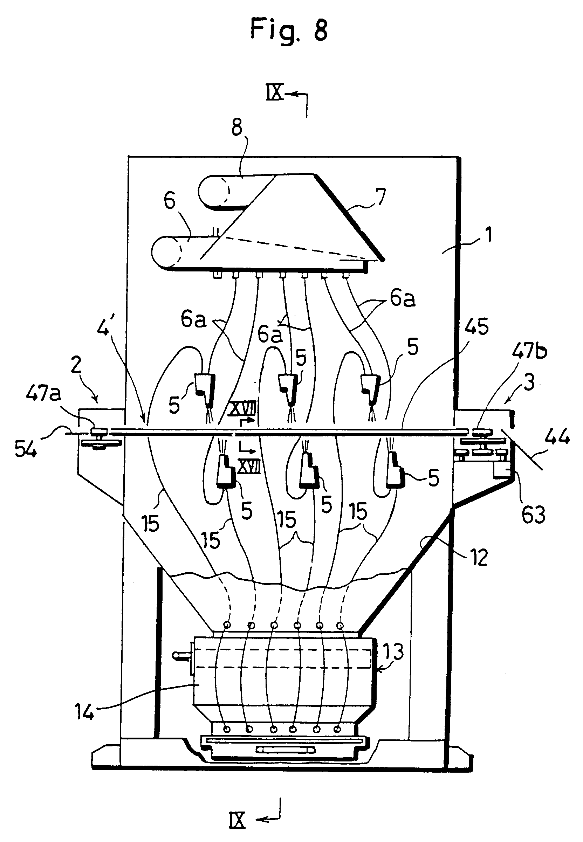

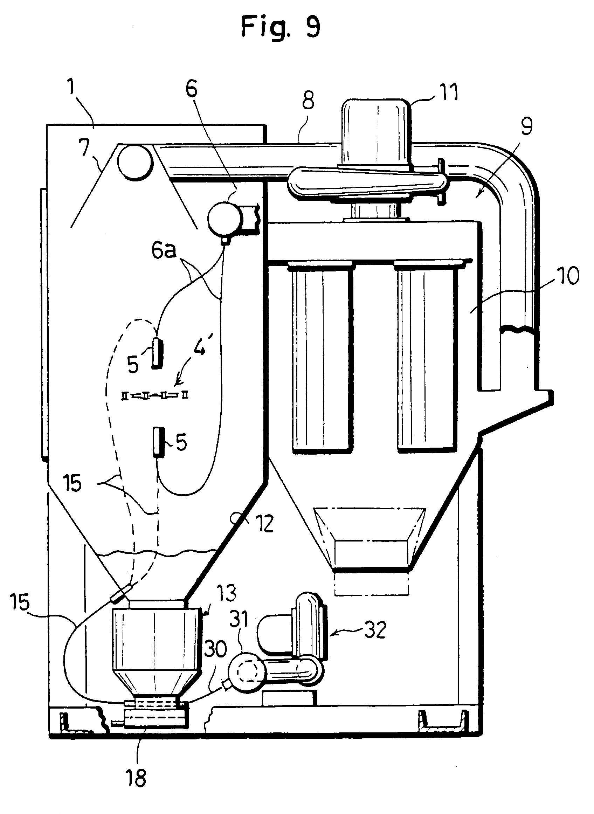

Figs. 8 through 17 show a fin removing apparatus according to a second embodiment of the present invention. The fin removing apparatus of this embodiment is similar to that of the first embodiment (Figs. 1-7) except for the incorporation of a modified transfer assembly 4'. Thus, this modified transfer assembly alone is described below for simplicity.

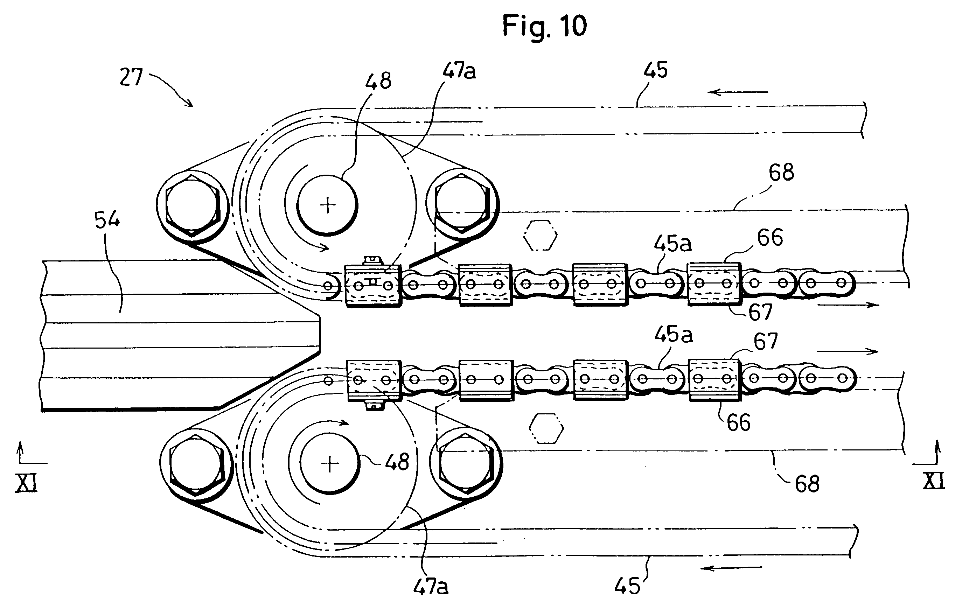

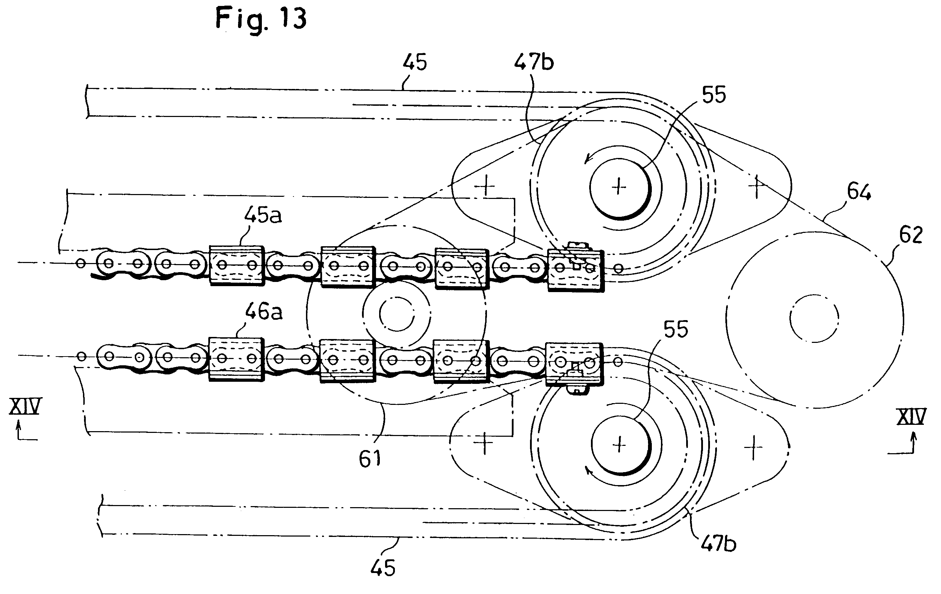

The modified transfer assembly 4' includes a parallel pair of endless transfer chains 45 spaced slightly from each other horizontally and each having a transfer path portion 45a. The endless transfer chains 45 are held in engagement with respective entry side sprockets 47a in the entry container 2 (Figs. 8 and 10), and with respective exit side sprockets 47b in the exit container 3 (Figs. 8 and 13).

According to the second embodiment, the exit side sprockets 47b are rotationally driven for moving the transfer chains 45. Further, the spacing between the entry side sprockets 47a is rendered adjustable, as also is the spacing between the exit side sprockets 47b.

As shown in Figs. 10 through 12, each of the entry side sprockets 47a is mounted at the upper end of a vertical support shaft 48 which is in turn mounted on a movable member 49. The movable member 49 is slidably supported between a pair of guide members 50a fixed in the entry container 2, so that the movable member 49 is slidable transversely of the leadframe transfer path. The movable member 49 has a pair of guide bores 51 for receiving a corresponding pair of adjusting rods 53 which extend transversely of the leadframe transfer path.

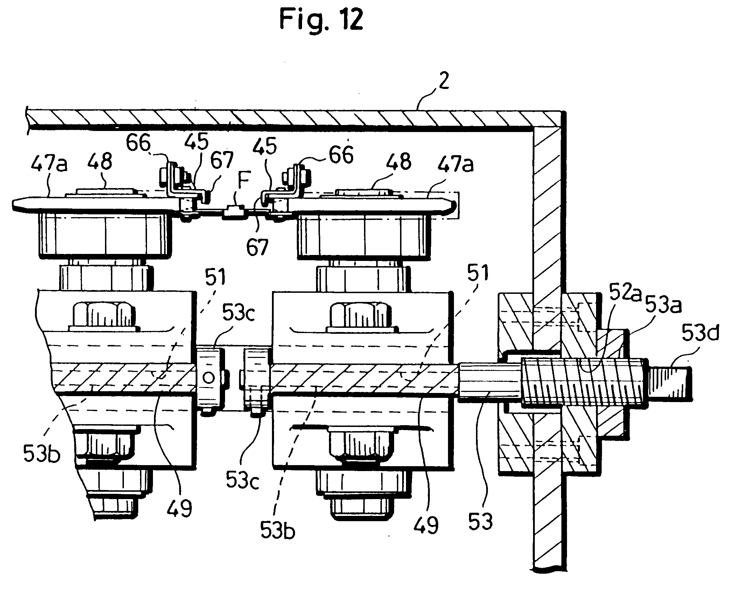

As shown in Fig. 12, each of the adjusting rods 53 has an externally threaded portion 53a for screwing into an internally threaded member 52a which is fixed to a wall of the entry container 2. The adjusting rod 53 further has a diametrically smaller fitting portion 53b received in the corresponding guide bore 51 of the movable member 49, an enlarged head 53c at an inner end of the rod 53 for engagement with the movable member 49, and an outer engaging end 53d for engagement with a suitable turning tool (not shown). Thus, by turning the adjusting rod 53, the movable member 49 may be made to displace transversely of the transfer path toward and away from the other movable member, thereby adjusting the spacing between the respective entry side sprockets 47a.

As shown in Figs. 8 and 10, a feed guide 54 is provided at the entry container 2 for introducing a leadframe F (Fig. 12) between the pair of entry side sprockets 47a, namely between the pair of endless transfer chains 45.

As shown in Figs. 13 through 15, the exit side sprockets 47b are supported substantially in the same manner as the entry side sprockets 47a. Specifically, each of the exit side sprockets 47b is mounted at the upper end of a vertical support shaft 55 which is in turn mounted on a movable member 56. The movable member 56 is slidably supported by a pair of guide members 50b fixed in the exit container 3, so that the movable member 56 is slidable transversely of the leadframe transfer path. The movable member has a pair of guide bores 57 for receiving a corresponding pair of adjusting rods 58.

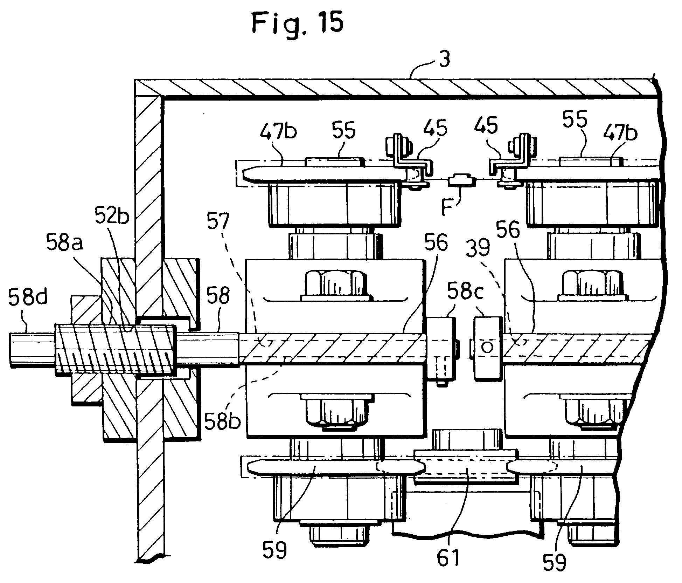

As shown in Fig. 15, each of the adjusting rods 58 has an externally thread portion 58a for screwing into an internally threaded member 52b which is fixed to a wall of the exit container 3. The adjusting rod 58 further has a diametrically smaller fitting portion 58b received in the corresponding guide bore 57 of the movable member 56, an enlarged head 58c at an inner end of the rod 58 for engagement with the movable member 56, and an outer engaging end 58d for engagement with a suitable turning tool (not shown). Thus, by turning the adjusting rod 58, the movable member 56 may be made to displace transversely of the transfer path toward and away from the other movable member, thereby adjusting the spacing between the respective exit side sprockets 47b.

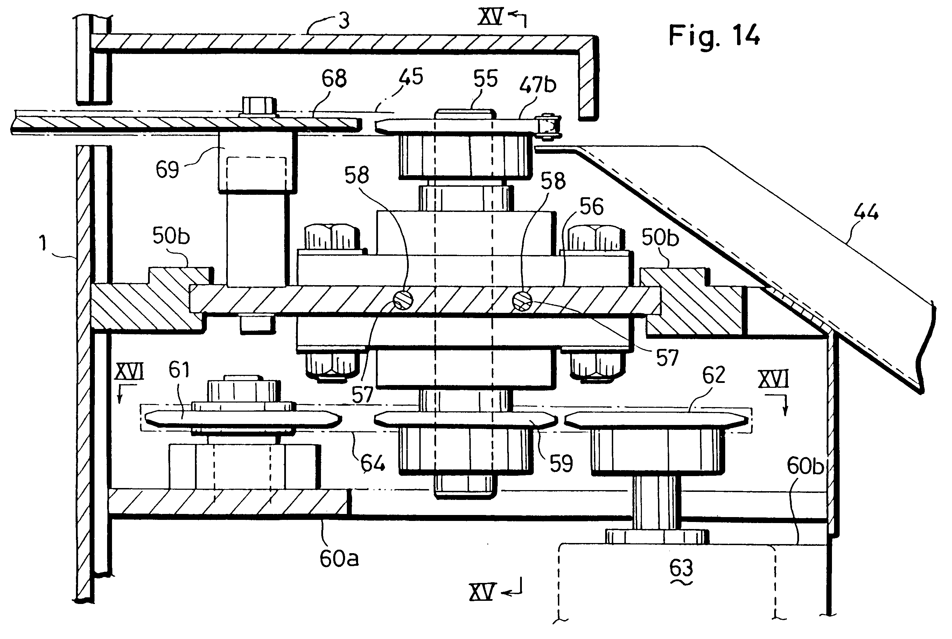

As shown in Figs. 13 through 16, the respective support shafts 55 for the exit side sprockets 47b have their lower ends provided with driven sprockets 59 which are equal in diameter. An idle sprocket 61 is rotatably mounted on a stationary mount 60a (see Fig. 14) within the exit container 3, whereas a drive sprocket 62 connected to a motor 63 (Fig. 14) is mounted on another stationary mount 60b. The respective sprockets 59, 61, 62 are all held at an equal height, as clearly appreciated from Figs. 14 and 15.

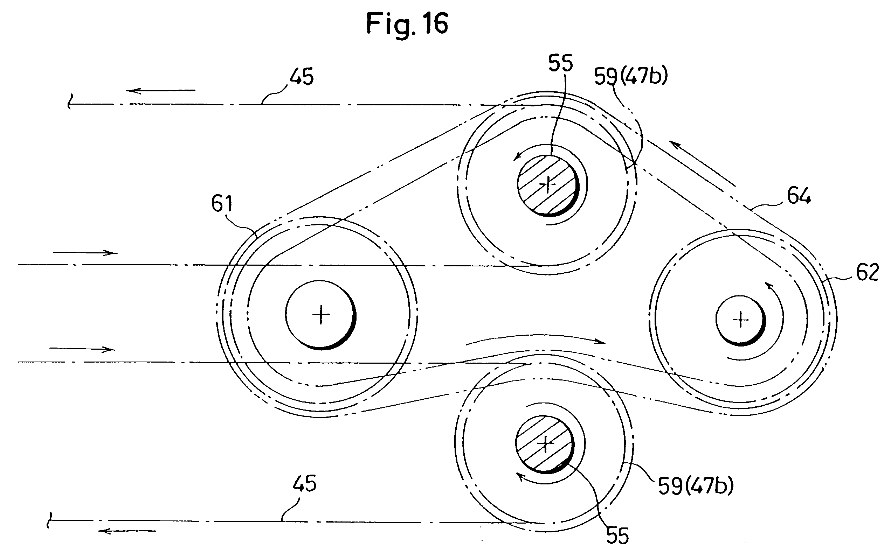

An endless drive chain 64 is guided by the respective sprockets 59, 61, 62 in engagement therewith. For causing the respective driven sprockets 59 to rotate in opposite directions, one of the driven sprockets 59 is made to internally contact the endless drive chain 64 while the other driven sprocket 59 is made to externally contact the same chain, as shown in Figs. 13 and 16. As a result, it is possible to move the transfer path portions 45a of the respective transfer chains 45 synchronously at the same speed and in the same transfer direction (namely, from the entry container 2 to the exit container 3).

Further, when the exit side sprockets 47b are moved transversely of the leadframe transfer path for a spacing adjustment, the driven sprockets 59 are also moved correspondingly. Thus, the endless drive chain 64 can be always held in non-loosening engagement with the sprockets 59, 61, 62 as long as the spacing adjustment is performed symmetrically with respect to both exit side sprockets 47b.

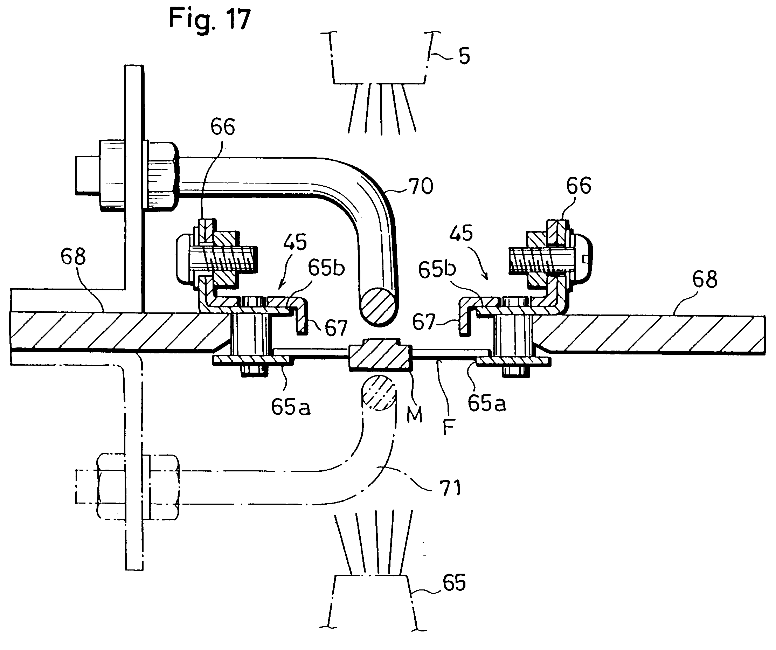

As better shown in Fig. 17, the respective transfer chains 45 have lower links 65a conveniently engageable, from below, with the longitudinal edges of the leadframe F for supporting the leadframe while transferring it. Further, the respective transfer chains 45 include selected upper links 65b (at a constant interval) each of which is provided with a riser portion 66 attached to a stopper segment 67 for preventing the leadframe F from unexpectedly lifting up.

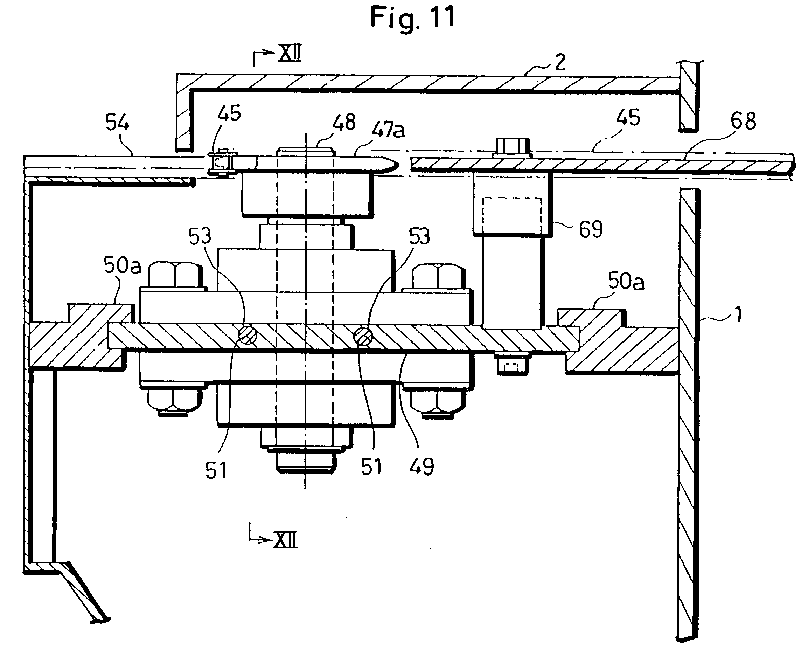

The respective transfer chains 45 are prevented from sagging by respective chain guides 68 inserted into the space between the lower links 65a and the upper links 65b. The chain guides 68 are mounted to the respective movable members 49, 56 by means of respective connectors 69 which are adjustable in height, as shown in Figs. 11 and 14. Therefore, the chain guides 68 are transversely adjustable together with the sprockets 47a, 47b in addition to being vertically adjustable in themselves.

Preferably, one of the chain guides 68 may fixedly carry an upper backup member 70 facing the cental portion of the leadframe F from above for preventing the leadframe F from elastically bending downward under the high speed abrasive blasting performed by the blasting nozzles 5. Further, the same chain guide 68 may alternatively or additionally carry a lower backup member 70 for preventing the leadframe F from elastically bending upward.

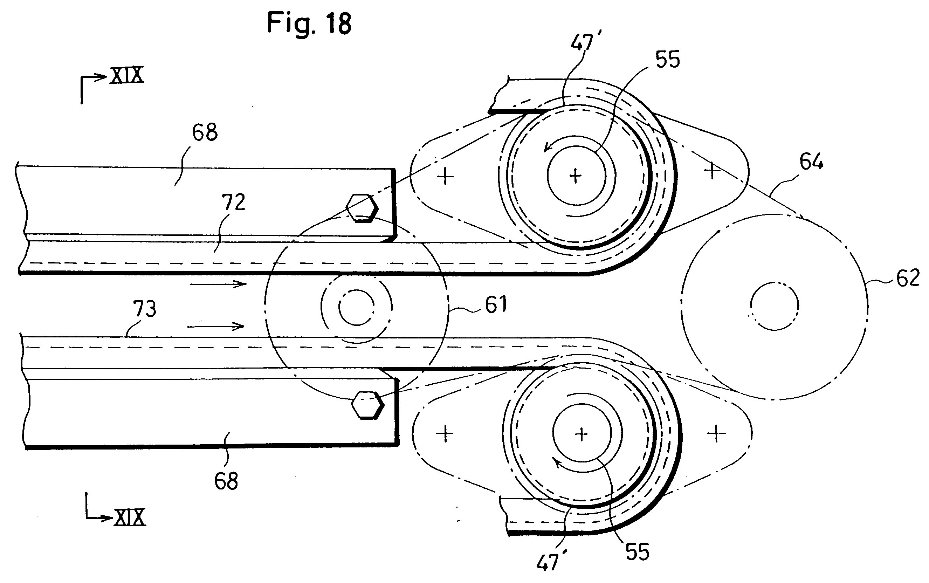

Figs. 18 and 19 shows a modification in which the transfer chains 45 of the second embodiment are replaced by a pair of endless transfer belts 72, and the toothed sprockets 47a, 47b of the second embodiment are replaced by non-tooth belt pulleys 47'. The transfer belts 72 are provided with at least one opposite pair of V-shaped grooves 73 for engagement with the longitudinal edges of the leadframe F. Preferably, the transfer belts 72 may be made of rubber so that the leadframe F can be held in a cushioned manner.

## Claims

1. An abrasive blasting apparatus comprising:
a blasting chamber (1);
at least one blasting nozzle (5) disposed in the blasting chamber (1);
air supplying means (6,6a) for supplying air to the blasting nozzle (5);
abrasive supplying means (15) for supplying an abrasive to the blasting nozzle (5) for discharging with the air; and
abrasive recovering means (13) connected to the abrasive supplying means (15) for collecting the discharged abrasive and for circulating the collected abrasive to the abrasive supplying means (15);
the abrasive recovering means (13) comprising at least one abrasive suction inlet (21a) arranged at a lower portion of the blasting chamber (1) and connected to the abrasive supplying means (15); characterised in that the abrasive recovering means (13) further comprises at least one air discharge pipe (26) having a discharge end (26a) in facing relation to the abrasive suction inlet (21a) with a clearance (29), the air discharge pipe (26) having a non-constricted air passage and being connected to a blower (32) which is separate from the air supplying means (6, 6a) for the blasting nozzle (5).

2. The blasting apparatus according to claim 1, wherein at least one of the abrasive suction inlet (21a) and the air discharge pipe (26) is positionally displaceable to adjust the clearance (29).

3. The blasting apparatus according to claim 1, wherein the air discharge pipe (26) is coaxial with the abrasive suction inlet (21a), the discharge pipe (26) having an outer diameter smaller than an inner diameter of the abrasive suction inlet (21a).

4. An apparatus for removing resin fins from a moulded leadframe (F), the apparatus comprising:
a blasting chamber (1);
a transfer assembly (4, 4') for transferring the leadframe (F) in the blasting chamber (1) substantially horizontally;
at least one blasting nozzle (5) disposed in the blasting chamber (1) and directed toward the leadframe (F) transferred by the transfer means (4, 4');
air supplying means (6, 6a) for supplying air to the blasting nozzle (5);
abrasive supplying means (15) for supplying an abrasive to the blasting nozzle (5) for discharging with the air toward the leadframe (F); and
abrasive recovering means (13) connected to the abrasive supplying means (15) for collecting the discharged abrasive and for circulating the collected abrasive to the abrasive supplying means (15);
the abrasive recovering means (13) comprising at least one abrasive suction inlet (21a) arranged at a lower portion of the blasting chamber (1) and connected to the abrasive supplying means (15); characterised in that the abrasive recovering means (13) further comprises at least one air discharge pipe (26) having a discharge end (26a) in facing relation to the abrasive suction inlet (21a) with a clearance (29), the air discharge pipe (26) having a non-constricted air passage and being connected to a blower which is separate from the air supplying means (6, 6a) for the blasting nozzle (5).

5. The fin removing apparatus according to claim 4, wherein the transfer assembly (4) comprises a parallel pair of rail members (33) arranged substantially horizontally in the blasting chamber (1) and spaced transversely of a leadframe transfer path for slidably supporting longitudinal edges of the leadframe (F), each of the rail members (33) having a V-shaped guide groove (34), the transfer assembly (4) further comprising a moving mechanism (36) for moving the leadframe (F) along the pair of rail members (33).

6. The fin removing apparatus according to claim 4, wherein the transfer assembly (4') comprises a pair of endless moving members (45, 72) arranged substantially horizontally in the blasting chamber (1) and spaced transversely of a leadframe transfer path for supporting longitudinal edges of the leadframe (F) while also moving the leadframe (F).

7. The fin removing apparatus according to claim 6, wherein the pair of endless moving members comprises a pair of endless transfer chains (45).

8. The fin removing apparatus according to claim 6, wherein the pair of endless moving members comprises a pair of endless transfer belts (72) having at least one opposite pair of V-shaped grooves (73) for engagement with the longitudinal edges of the leadframe (F).

9. The fin removing apparatus according to claim 6, wherein the spacing between the pair of endless moving members (45, 72) is adjustable by an adjusting mechanism (49, 52a, 53).

10. The fin removing apparatus according to claim 9, wherein the adjusting mechanism comprises at least one pair of movable members (49) supporting the pair of endless moving members (45, 72), the movable members (49) being spaced transversely of the leadframe transfer path, the adjusting mechanism further comprising screw means (52a, 53) for moving the movable members (49) toward and away from each other.

11. The fin removing apparatus according to claim 5, wherein the moving mechanism (36) of the transfer assembly (4) comprises a plurality of engaging pawls (37) spaced along the leadframe transfer path, each of the engaging pawls (37) coming into pushing engagement with the leadframe (F).

## Patentansprüche

1. Schleifmittelstrahlvorrichtung, die
eine Strahlkammer (1);
mindestens eine in der Strahlkammer (1) angeordnete Strahldüse (5);
Luftzufuhrmittel (6, 6a) zur Zufuhr von Luft zu der Strahldüse (5);
Schleifmittelzufuhrmittel (15) zur Zufuhr eines Schleifmittels zu der Strahldüse (5) für einen Ausstoß mit der Luft; und
mit den Schleifmittelzufuhrmitteln (15) verbundene Schleifmittelsammelmittel (13) zum Sammeln des ausgestoßenen Schleifmittels und zur Kreisführung des gesammelten Schleifmittels zu den Schleifmittelzufuhrmitteln (15) umfaßt;
wobei die Schleifmittelsammelmittel (13) mindestens einen Saugeinlaß (21a) umfassen, welcher in einem unteren Bereich der Strahlkammer (1) angeordnet und mit den Schleifmittelzufuhrmitteln (15) verbunden ist;
dadurch gekennzeichnet,
daß die Schleifmittelsammelmittel (13) des weiteren mindestens ein Luftauslaßrohr (26) umfassen, welches ein mit einem Zwischenraum (29) auf den Schleifmittelsaugeinlaß (21a) weisend angeordnetes Auslaßende (26a) aufweist, und daß das Luftauslaßrohr (26) einen nicht-eingeengten Luftdurchgang aufweist und mit einem von den Luftzufuhrmitteln (6, 6a) für die Strahldüse (5) getrennten Gebläse (32) verbunden ist.

2. Strahlvorrichtung nach Anspruch 1, bei welcher der Schleifmittelsaugeinlaß (21a) und/oder das Lauftauslaßrohr (26) in seiner Position veränderbar ist, um den Zwischenraum (29) einzustellen.

3. Strahlvorrichtung nach Anspruch 1, bei welcher das Luftauslaßrohr (26) koaxial bezüglich des Schleifmittelsaugeinlasses (21a) angeordnet ist und das Auslaßrohr (26) einen äußeren Durchmesser aufweist, der kleiner als der innere Durchmesser des Schleifmittelsaugeinlasses (21a) ist.

4. Vorrichtung zum Entfernen von Kunststoffgraten an einem umgossenen Leiterrahmen (F), die
eine Strahlkammer (1);
eine Transporteinrichtung (4, 4') zum im wesentlichen horizontalen Transport des Leiterrahmens (F) in der Strahlkammer (1);
mindestens eine in der Strahlkammer (1) angeordnete und auf den durch die Transporteinrichtung (4, 4') transportierten Leiterrahmen (F) gerichtete Strahldüse (5);
Luftzufuhrmittel (6, 6a) zur Zufuhr von Luft zu der Strahldüse (5);
Schleifmittelzufuhrmittel (15) zur Zufuhr eines Schleifmittels zu der Strahldüse (5) für einen Ausstoß mit der Luft in Richtung auf den Leiterrahmen (F); und mit den Schleifmittelzufuhrmitteln (15) verbundene Schleifmittelsammelmittel (13) zum Sammeln des ausgestoßenen Schleifmittels und zur Kreisführung des gesammelten Schleifmittels zu den Schleifmittelzufuhrmitteln (15) umfaßt;
wobei die Schleifmittelsammelmittel (13) mindestens einen Saugeinlaß (21a) umfassen, welcher in einem unteren Bereich der Strahlkammer (1) angeordnet und mit den Schleifmittelzufuhrmitteln (15) verbunden ist;
dadurch gekennzeichnet,
daß die Schleifmittelsammelmittel (13) des weiteren mindestens ein Luftauslaßrohr (26) umfassen, welches ein mit einem Zwischenraum (29) auf den Schleifmittelsaugeinlaß (21a) weisend angeordnetes Auslaßende (26a) aufweist, und daß das Luftauslaßrohr (26) einen nicht-eingeengten Luftdurchgang aufweist und mit einem von den Luftzufuhrmitteln (6, 6a) für die Strahldüse (5) getrennten Gebläse (32) verbunden ist.

5. Gratentfernungsvorrichtung nach Anspruch 4, bei welcher die Transporteinrichtung (4) ein paralleles Paar Führungsschienen (33) umfaßt, die im wesentlichen horizontal in der Strahlkammer (1) und seitlich von einem Leiterrahmentransportweg beabstandet angeordnet sind, um Längskanten des Leiterrahmens (F) verschiebbar zu halten, wobei jede der Führungsschienen (33) eine V-förmige Führungsnut (34) aufweist und die Transporteinrichtung des weiteren eine Antriebseinrichtung (36) zum Antrieb des Leiterrahmens (F) entlang des Führungsschienenpaars (33) umfaßt.

6. Gratentfernungsvorrichtung nach Anspruch 4, bei welcher die Transporteinrichtung (4') ein Paar endloser Transporteinrichtungen (45, 72) umfaßt, die im wesentlichen horizontal in der Strahlkammer (1) und seitlich von einem Leiterrahmentransportweg beabstandet angeordnet sind, um Längskanten des Leiterrahmens (F) zu halten, während gleichfalls der Leiterrahmen (F) transportiert wird.

7. Gratentfernungsvorrichtung nach Anspruch 6, bei welcher das Paar endloser Transporteinrichtungen ein Paar endloser Transportketten (45) umfaßt.

8. Gratentfernungsvorrichtung nach Anspruch 6, bei welcher das Paar endloser Transporteinrichtungen ein Paar endloser Transportgurte (72) umfaßt, die zumindest ein Paar gegenüberliegend angeordneter, V-förmiger Nuten (73) zum Eingriff mit den Längskanten des Leiterrahmens (F) aufweisen.

9. Gratentfernungsvorrichtung nach Anspruch 6, bei welcher der Abstand zwischen dem Paar endloser Transporteinrichtungen (45, 72) mittels einer Einstelleinrichtung (49, 52a, 53) einstellbar ist.

10. Gratentfernungsvorrichtung nach Anspruch 9, bei welcher die Einstelleinrichtung mindestens ein Paar beweglicher Elemente (49) umfaßt, die das Paar endloser Transporteinrichtungen (45, 72) tragen, wobei die beweglichen Elemente (49) seitlich des Leiterrahmentransportweges beabstandet sind und die Einstelleinrichtung des weiteren zur Bewegung der beweglichen Elemente (49) aufeinander zu und voneinander weg Schraubvorrichtungen (52a, 53) umfaßt.

11. Gratentfernungsvorrichtung nach Anspruch 5, bei welcher die Antriebseinrichtung (36) der Transporteinrichtung (4) eine Vielzahl Mitnahmeklinken (37) umfaßt, die entlang des Leiterrahmentransportweges voneinander beabstandet vorgesehen sind, wobei jede der Klinken (37) in antreibenden Eingriff mit der Leiterrahmen (F) kommt.

## Revendications

1. Dispositif de projection d'abrasif comprenant :
une chambre d'abrasion (1) ;
au moins une buse d'éjection (5) disposée dans la chambre d'abrasion (1);
des moyens de fourniture d'air (6,6a) pour amener de l'air à la buse d'éjection (5) ;
des moyens de fourniture d'abrasif (15) pour amener un abrasif à la buse d'éjection (5) afin de l'éjecter avec l'air ; et
des moyens de récupération d'abrasif (13) raccordés aux moyens de fourniture d'abrasif (15) pour collecter l'abrasif éjecté et recycler l'abrasif collecté vers le moyens de fourniture d'abrasif (15) ;
les moyens de récupération d'abrasif (13) comprenant au moins une entrée d'aspiration d'abrasif (21a) située à une partie inférieure de la chambre d'abrasion (1) et connectée aux moyens de fourniture d'abrasif (15); caractérisé en ce que les moyens de récupération d'abrasif (13) comprennent en outre au moins un tube de sortie d'air (26) ayant une extrémité de sortie (26a) en face de l'entrée d'aspiration d'abrasif (21a), avec un certain intervalle (29), le tube de sortie d'air (26) ayant un passage d'air non étranglé et étant connecté à un appareil de soufflage (32) qui est distinct des moyens de fourniture d'air (6,6a) à la buse d'éjection (5).

2. Dispositif de projection d'abrasif suivant la revendication 1, dans lequel au moins un de l'entrée d'aspiration d'abrasif (21a) et du tube de sortie d'air (26) est déplaçable en position pour régler l'intervalle (29).

3. Dispositif de projection d'abrasif suivant la revendication 1, dans lequel le tube de sortie d'air (26) est coaxial à l'entrée d'aspiration d'abrasif (21a), le tube de sortie d'air (26) ayant un diamètre extérieur plus petit qu'un diamètre intérieur de l'entrée d'aspiration d'abrasif (21a).

4. Dispositif pour éliminer les bavures de résine d'un bloc de montage moulé (F), le dispositif comprenant :
une chambre d'abrasion (1) ;
un ensemble de transfert (4,4') pour transférer le cadre de montage (F) dans la chambre d'abrasion (1) sensiblement horizontalement ;
au moins une buse d'éjection (5) disposée dans la chambre d'abrasion (1) et dirigée vers le cadre de montage (F) transféré par les moyens de transfert (4,4') ;
des moyens de fourniture d'air (6,6a) pour amener de l'air à la buse d'éjection (5) ;
des moyens de fourniture d'abrasif (15) pour amener un abrasif à la buse d'éjection (5) pour éjection avec l'air vers le cadre de montage (F) ; et
des moyens de récupération d'abrasif (13) connectés aux moyens de fourniture d'abrasif (15), pour collecter l'abrasif éjecté et recycler l'abrasif collecté vers les moyens de fourniture d'abrasif (15) ;
les moyens de récupération d'abrasif (13) comprenant au moins une entrée d'aspiration d'abrasif (21a) disposé dans une partie inférieure de la chambre d'abrasion (1) et connectée aux moyens de fourniture d'abrasif (15) ;
caractérisé en ce que les moyens de récupération d'abrasif (13) comprennent en outre au moins un tube de sortie d'air (26) ayant une extrémité de sortie (26a) en face de l'entrée d'aspiration d'abrasif (21a), avec un intervalle (29), le tube de sortie d'air (26) ayant un passage d'air non étranglé et étant connecté à un appareil de soufflage qui est distinct des moyens de fourniture d'air (6,6a) à la buse d'éjection (5).

5. Dispositif d'élimination de bavures suivant la revendication 4,dans lequel l'ensemble de transfert (4) comprend deux rails parallèles (33) agencés sensiblement horizontalement dans la chambre d'abrasion (1) et espacés transversalement d'un chemin de transfert de cadre de montage pour supporter de façon coulissante les bords longitudinaux du cadre de montage (F), chacun des rails (33) comportant une rainure de guidage en forme de V (34), l'ensemble de transfert (4) comprenant en outre un mécanisme de déplacement (36) pour déplacer le cadre de montage (F) le long des deux rails (33).

6. Dispositif d'élimination de bavures suivant la revendication 4, dans lequel l'ensemble de transfert (4') comprend deux éléments de déplacement sans fin (45,72) agencés sensiblement horizontalement dans la chambre d'abrasion (1) et espacés transversalement d'un chemin de transfert de cadre de montage pour supporter les bords longitudinaux du cadre de montage (F) tout en déplaçant également le cadre de montage (I).

7. Dispositif d'élimination de bavures suivant la revendication 6, dans lequel les deux éléments de déplacement sans fin comprennent deux chaînes de transfert sans fin (45).

8. Dispositif d'élimination de bavures suivant la revendication 6, dans lequel les deux éléments de déplacement sans fin comprennent deux bandes de transfert sans fin (72) présentant au moins deux rainures opposées en forme de V (73) pour engagement avec les bords longitudinaux du cadre de montage (F).

9. Dispositif d'élimination de bavures suivant la revendication 6, dans lequel l'espacement entre les deux éléments de déplacement sans fin (45,72) est réglable par un mécanisme de réglage (49,52a,53).

10. Dispositif d'élimination de bavures suivant la revendication 9, dans lequel le mécanisme de réglage comprend au moins deux éléments mobiles (49) supportant les deux éléments de déplacement sans fin (45,72), les éléments mobiles (49) étant espacés transversalement du chemin de transfert de cadre de montage, le mécanisme de réglage comprenant en outre des moyens à vis (52a,53) pour rapprocher et éloigner les éléments mobiles (49)l'un de l'autre.

11. Dispositif d'élimination de bavures suivant la revendication 5, dans lequel le mécanisme de déplacement (36) de l'ensemble de transfert (4) comprend une pluralité de doigts d'attaque (37) espacés le long du chemin de transfert de cadre de montage, chacun des doigts d'attaque (37) venant en contact de poussée avec le cadre de montage (7).
